# EUROPEAN PATENT APPLICATION

(11) **EP 4 776 812 A2**
(43) Date of publication of application: **15.07.2026**
(21) Application number: 26151425.1
(22) Date of filing: 12.01.2026
(51) Int. Cl.: H10K 59/80

(54) **WINDOW MEMBER, DISPLAY DEVICE COMPRISING THE SAME, AND ELECTRONIC DEVICE**

(30) Priority: 13.01.2025 KR 20250004907
(71) Applicant: Samsung Display Co., Ltd., Yongin-si, Gyeonggi-do 17113 (KR)
(72) Inventor: SEO, Hyun Seung, 17113 Yongin-si (KR); KIM, Seung, 17113 Yongin-si (KR); KIM, Seung Ho, 17113 Yongin-si (KR); MIN, Ji Won, 17113 Yongin-si (KR); HWANG, Seong Jin, 17113 Yongin-si (KR)
(74) Representative: Taor, Simon Edward William

(57) **Abstract**

A window member comprises a cover window, an optical member disposed on the cover window, and a functional member disposed on the optical member. The optical member comprises a first refractive layer disposed on the cover window, and at least two groups disposed on the first refractive layer. Each of the at least two groups comprises a second refractive layer and a third refractive layer. The second refractive layer and the third refractive layer have different refractive indices from each other. The first refractive layer has a first refractive index between a second refractive index of the second refractive layer and a third refractive index of the third refractive layer. The first refractive layer contains at least silicon.

## Description

### 1. TECHNICAL FIELD

The present disclosure relates to a window member, a display device including the same, and an electronic device.

### 2. DISCUSSION OF RELATED ART

As the information-oriented society evolves, various demands for display devices are increasing. For example, display devices are being applied in a variety of electronic devices, such as smart phones, digital cameras, laptop computers, navigation devices, and smart televisions.

Display devices include flat panel display devices such as a liquid-crystal display device, a field emission display device, and a light-emitting display device. Light-emitting display devices include an organic light-emitting display device including organic light-emitting elements, an inorganic light-emitting display device including inorganic light-emitting elements such as inorganic semiconductor, and a micro light-emitting display device including micro light-emitting elements.

When a display device is exposed to external light such as various illumination lights and natural light, the image created in the display device may not be clearly seen by the user due to reflected light, or may cause fatigue to the user's eyes. Therefore, the demand for antireflection is increasing to provide a display device with high quality images.

### SUMMARY

Aspects of the present disclosure provide a window member that can reduce reflectance and increase transmittance and hardness, a display device including the same, and an electronic device.

It should be noted that objects of the present disclosure are not limited to the above-mentioned object; and other objects of the present disclosure will be apparent to those skilled in the art from the following descriptions.

According to an embodiment of the present disclosure, a window member comprises a cover window, an optical member disposed on the cover window, and a functional member disposed on the optical member. The optical member comprises a first refractive layer disposed on the cover window, and at least two groups disposed on the first refractive layer. Each of the at least two groups comprises a second refractive layer and a third refractive layer. The second refractive layer and the third refractive layer have different refractive indices from each other. The first refractive layer has a first refractive index between a second refractive index of the second refractive layer and a third refractive index of the third refractive layer. The first refractive layer contains at least silicon.

In an embodiment, the first refractive layer comprises an oxide containing silicon, an oxynitride containing silicon, or a nitride containing silicon.

In an embodiment, the first refractive layer further contains a metal, and the metal comprises aluminum.

In an embodiment, the second refractive index of the second refractive layer is greater than the first refractive index of the first refractive layer and the third refractive index of the third refractive layer.

In an embodiment, the third refractive index of the third refractive layer is less than the first refractive index of the first refractive layer and the second refractive index of the second refractive layer.

In an embodiment, the third refractive layer is spaced apart from an upper surface of the cover window.

In an embodiment, the first refractive layer is in direct contact with a surface of the cover window, the second refractive layer is disposed on the first refractive layer, and the third refractive layer is disposed on the second refractive layer.

In an embodiment, each of the at least two groups has the second refractive layers and the third refractive layers alternately stacked on one another.

In an embodiment, the first refractive layer has a first refractive index between a fourth refractive index of the cover window and the second refractive index of the second refractive layer.

In an embodiment, the first refractive index of the first refractive layer is in a range of about 1.4 to about 1.9, the second refractive index of the second refractive layer is in a range of about 1.9 to about 2.3, and the third refractive index of the third refractive layer is in a range of about 1.3 to about 1.5.

In an embodiment, the first refractive layer comprises an oxynitride containing at least silicon, and the first refractive layer is in direct contact with a surface of the cover window.

In an embodiment, a thickness of the first refractive layer ranges is in a range of about 75% to about 95% of a thickness of the third refractive layer disposed at an uppermost layer of the optical member.

In an embodiment, a thickness of the second refractive layer ranges is in a range of about 130% to about 240% of a thickness of the third refractive layer disposed at an uppermost layer of the optical member.

In an embodiment, a thickness of the third refractive layer is in a range of about 1% to about 30% of a total thickness of the optical member.

In an embodiment, the functional member comprises an anti-fingerprint layer, wherein a refractive index of the anti-fingerprint layer is equal to the third refractive index of the third refractive layer in direct contact with the anti-fingerprint layer.

In an embodiment, an upper surface of the cover window facing the first refractive layer comprises a rough structure.

In an embodiment, the first refractive layer comprises an oxynitride containing silicon, the second refractive layer comprises a nitride containing silicon, and the third refractive layer comprises an oxide containing silicon.

According to an embodiment of the present disclosure, a window member comprises a cover window, an optical member disposed on the cover window, and a functional member disposed on the optical member. The optical member comprises a first refractive layer disposed on the cover window and comprising at least silicon, a third refractive layer disposed on the first refractive layer and having a third refractive index greater than a first refractive index of the first refractive layer, and at least one group including a second refractive layer disposed on the third refractive layer and having a second refractive index less than the third refractive index of the third refractive layer and the third refractive layer are stacked alternately. The first refractive layer is in direct contact with the cover window.

In an embodiment, the first refractive layer comprises an oxide containing silicon, a nitride containing silicon, or an oxynitride containing silicon.

In an embodiment, the first refractive layer further contains a metal, and the metal comprises aluminum.

In an embodiment, the first refractive layer comprises silicon nitride or aluminum silicon nitride.

In an embodiment, the second refractive layer comprises aluminum silicon nitride, and the third refractive layer comprises silicon oxide.

According to an embodiment of the present disclosure, a display device comprises a display panel, an adhesive member arranged on the display panel, a cover window arranged on the adhesive member, an optical member arranged on the cover window, and a functional member arranged on the optical member, wherein the optical member comprises, a first refractive layer located on the cover window, and at least two groups located on the first refractive layer and each comprising a second refractive layer and a third refractive layer, the second refractive layer and the third refractive layer having different refractive indices, and wherein the first refractive layer has a refractive index between the refractive index of the second refractive layer and the refractive index of the third refractive layer, and contains at least silicon.

In an embodiment, the optical member is formed by depositing the first refractive layer on the cover window, depositing the second refractive layer on the first refractive layer, and depositing the third refractive layer on the second refractive layer.

According to an embodiment of the present disclosure, an electronic device comprises a display device providing images, a processor providing an image data signal to the display device, a memory storing a data signal for driving, and a power module generating power. The display device comprises, a display panel, an adhesive member arranged on the display panel, a cover window arranged on the adhesive member, an optical member arranged on the cover window, and a functional member arranged on the optical member. The optical member comprises, a first refractive layer disposed on the cover window, and at least two groups disposed on the first refractive layer. Each of the at least two groups comprising a second refractive layer and a third refractive layer, the second refractive layer and the third refractive layer having different refractive indices from each other. The first refractive layer has a first refractive index between a second refractive index of the second refractive layer and a third refractive index of the third refractive layer. The first refractive layer contains at least silicon.

According to an aspect, there is provided a window member as set out in claim 1. Additional features are set out in claims 2 to 14. According to an aspect, there is provided an electronic device as set out in claim 15.

According to an embodiment of the present disclosure, a window member includes refractive layers containing silicon to increase the hardness of the window member and increase the issue of warpage.

In addition, according to an embodiment of the present disclosure, a window member can increase the display quality of a display device by increasing the transmittance and reducing the reflectance. In particular, it is possible to prevent incomplete curing of an adhesive member that adheres a display panel with a window member by increasing the transmittance of light in the ultraviolet wavelength range.

In addition, according to an embodiment of the present disclosure, a display device and an electronic device including a window member can increase display quality, impact resistance, and the issue of warpage.

It should be noted that effects of the present disclosure are not limited to those described above and other effects of the present disclosure will be apparent to those skilled in the art from the following descriptions.

### BRIEF DESCRIPTION OF THE DRAWINGS

The above and other aspects and features of the present disclosure will become more apparent by describing in detail non-limiting embodiments thereof with reference to the attached drawings, in which:
FIG. 1 is a plan view of an electronic device according to an embodiment of the present disclosure.
FIG. 2 is a perspective view showing the electronic device when it is folded according to an embodiment of the present disclosure.
FIG. 3 is a perspective view showing the electronic device of FIG. 2 when it is unfolded according to an embodiment of the present disclosure.
FIG. 4 is a cross-sectional view showing a display device included in an electronic device according to an embodiment of the present disclosure.
FIG. 5 is a perspective view showing a display device according to an embodiment of the present disclosure.
FIG. 6 is a cross-sectional view of the display device of FIG. 5 seen from the side according to an embodiment of the present disclosure.
FIG. 7 is a schematic cross-sectional view of the display panel of FIG. 6 according to an embodiment of the present disclosure.
FIG. 8 is a cross-sectional view schematically showing a window member according to an embodiment of the present disclosure.
FIG. 9 is a cross-sectional view showing in detail the window member according to an embodiment of the present disclosure.
FIG. 10 is a view schematically showing an optical member according to an embodiment of the present disclosure.
FIG. 11 is a cross-sectional view schematically showing a window member according to an embodiment of the present disclosure.
FIG. 12 is a cross-sectional view schematically showing a window member according to still an embodiment of the present disclosure.
FIG. 13 is a cross-sectional view schematically showing a window member according to an embodiment of the present disclosure.
FIG. 14 is a graph showing the transmittance according to the wavelength of window members fabricated according to Comparative Example 1, Comparative Example 2, and Example 1.
FIG. 15 is a graph showing the reflectance according to the wavelength of window members fabricated according to Comparative Example 1, Comparative Example 2, and Example 1.
FIG. 16 is a graph showing the transmittance according to the wavelength of window members fabricated according to Comparative Example 2, Example 1, and Example 2.
FIG. 17 is a graph showing the reflectance according to the wavelength of window members fabricated according to Comparative Example 2, Example 1, and Example 2.
FIG. 18 is a graph showing the transmittance according to the wavelength of window members fabricated according to Comparative Example 2, Example 1, and Example 3.
FIG. 19 is a graph showing the reflectance according to the wavelength of window members fabricated according to Comparative Example 2, Example 1, and Example 3.
FIG. 20 is a block diagram of an electronic device according to an embodiment of the present disclosure.
FIG. 21 is a view showing electronic devices according to a variety of embodiments of the present disclosure.

### DETAILED DESCRIPTION OF EMBODIMENTS

The present invention will now be described more fully hereinafter with reference to the accompanying drawings, in which non-limiting embodiments of the present disclosure are shown. This invention may, however, be embodied in different forms and should not be construed as limited to the described embodiments set forth herein.

It will also be understood that when a layer is referred to as being "on" another layer or substrate, it can be directly on the other layer or substrate, or intervening layers may also be present. When a layer is referred to as being "directly on" another layer or substrate, no intervening layers may be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, embodiments of the present disclosure will be described with reference to the accompanying drawings.

The present disclosure concerns a window member including an optical member having first to third refractive layers having different refractive indices from each other. The first refractive layer is disposed on the cover window. In some embodiments, the second refractive layer is disposed on the first refractive layer. At least one group consisting of the third refractive layer and the second refractive layer alternately stacked is disposed on the second refractive layer or the first refractive layer. A functional member is disposed on the at least one group.

The refractive layers have respective refractive indexes that reduce the differences in the refractive indexes at interfaces between the layers to decrease the amount of reflected external light incident from the outside. The respective thicknesses of the refractive layers may further reduce the reflectance by causing destructive interference. Therefore, the window member may increase the quality of the images that are displayed by the display device. Refractive layers of the optical member may contain silicon to increase the hardness of the window member and decrease warpage of the window member.

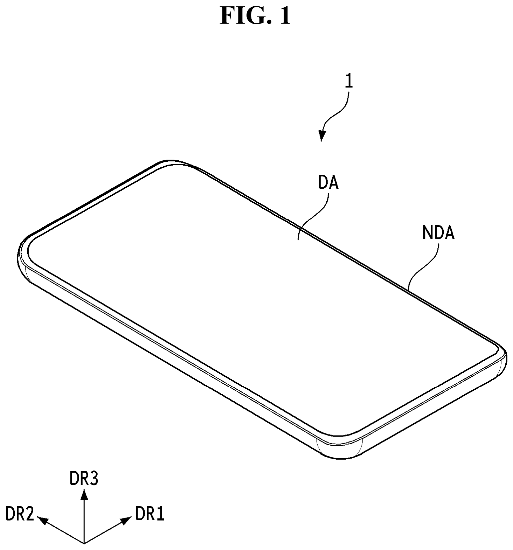

FIG. 1 is a plan view of an electronic device according to an embodiment of the present disclosure.

Referring to FIG. 1, an electronic device 1 displays moving images and/or still images. The electronic device 1 may refer to any electronic device that provides a display screen. For example, in an embodiment the electronic device 1 may include a television set, a laptop computer, a monitor, an electronic billboard, the Internet of Things devices, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console and a digital camera, a camcorder, etc. However, embodiments of the present disclosure are not necessarily limited thereto and the electronic device 1 may be various different small-sized, medium-sized or large-sized electronic devices.

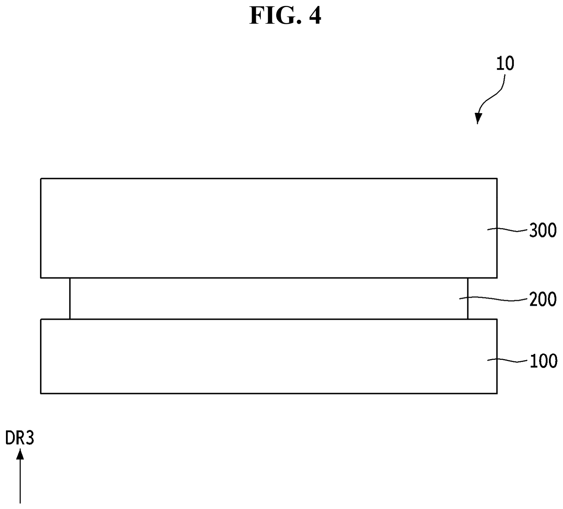

The electronic device 1 may include a display device 10 (see FIG. 4) for providing a display screen. Examples of the display device may include an inorganic light-emitting diode display device, an organic light-emitting display device, a quantum-dot light-emitting display device, a plasma display device, a field emission display device, etc. In the following description, an organic light-emitting diode display device is employed as an example of the display device, but embodiments of the present disclosure are not necessarily limited thereto. Any other display device may be employed as long as the technical idea of the present disclosure can be equally applied.

The shape of the electronic device 1 may be modified in a variety of ways. For example, the electronic device 1 may have shapes (e.g., in a plan view), such as a rectangle with longer lateral sides, a rectangle with longer vertical sides, a square, a quadrangle with rounded corners (e.g., vertices), other polygons, a circle, etc. In an embodiment, the shape of a display area DA of the electronic device 1 (e.g., in a plan view) may also be similar to the overall shape of the electronic device 1. In the example shown in FIG. 1, the electronic device 1 has a rectangular shape with the longer sides in a second direction DR2.

The electronic device 1 may include the display area DA and a non-display area NDA. In the display area DPA, images can be displayed. In the non-display area NDA, images are not displayed. The display area DPA may be referred to as an active area, while the non-display area NDA may also be referred to as an inactive area. The display area DA may generally occupy the center of the electronic device 1.

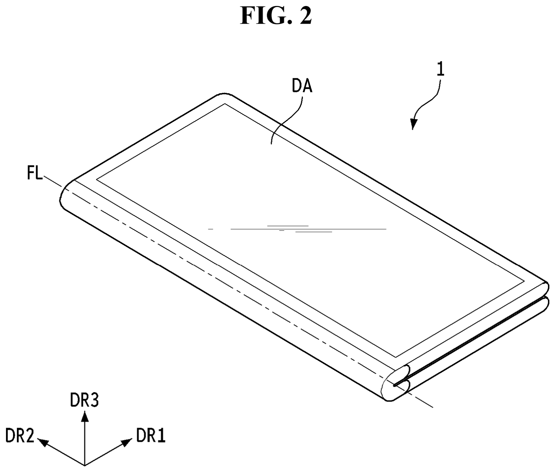

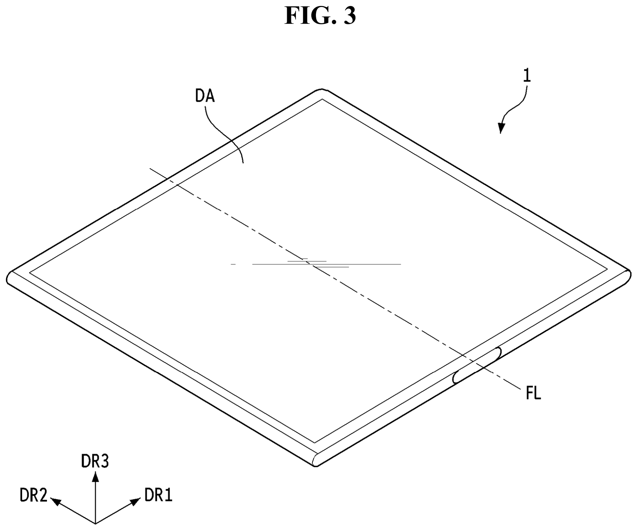

FIG. 2 is a perspective view showing the electronic device according to an embodiment when it is folded. FIG. 3 is a perspective view showing the electronic device of FIG. 2 when it is unfolded.

Referring to FIGS. 2 and 3, the electronic device 1 according to an embodiment may be a foldable electronic device. The electronic device 1 may be folded along a folding axis FL. The display area DA may be located on the outside and/or inside of the electronic device 1. According to an embodiment, the display area DA is located on each of the outside and inside of the electronic device 1 of FIGS. 2 and 3.

As shown in FIG. 2, the display area DA may be located on the outside of the electronic device 1. For example, the outer surface of the electronic device 1 when it is folded may include the display area DA, and the inner surface of the electronic device 1 when it is unfolded may also include the display area DA.

FIG. 4 is a cross-sectional view showing a display device included in an electronic device according to an embodiment of the present disclosure.

Referring to FIG. 4, the display device 10 according to the embodiment may include a display panel 100, an adhesive member 200 and a window member 300.

The display panel 100 may be a panel for displaying images. In an embodiment, the display panel 100 may be an organic light-emitting display panel including an organic light-emitting layer, a quantum-dot light-emitting display panel including a quantum-dot light-emitting layer, an inorganic light-emitting display panel using inorganic semiconductor elements as the light-emitting elements, and a micro light-emitting display panel using micro light-emitting diodes as the light-emitting elements. In the following description, an organic light-emitting display panel is employed as the display panel 100. It is, however, to be understood that embodiments of the present disclosure are not necessarily limited thereto.

The window member 300 may be attached to the front surface of the display panel 100 by the adhesive member 200. The window member 300 may include a cover window, an optical member, and a functional member. In an embodiment, the cover window may be made of a transparent material, such as glass or plastic. The optical member may lower the reflectance of external light and increase the transmittance of light output from the display panel 100. The functional member may provide a function such as anti-fingerprint to the surface of the window member 300. The window member 300 will be described in detail later.

The adhesive member 200 may be a transparent adhesive film or a transparent adhesive resin. For example, in an embodiment the adhesive member 200 may include a transparent adhesive such as a pressure sensitive adhesive (PSA), an optically clear adhesive (OCA), and an optically clear resin (OCR). The adhesive member 200 may include a material that can be cured with ultraviolet (UV) ray.

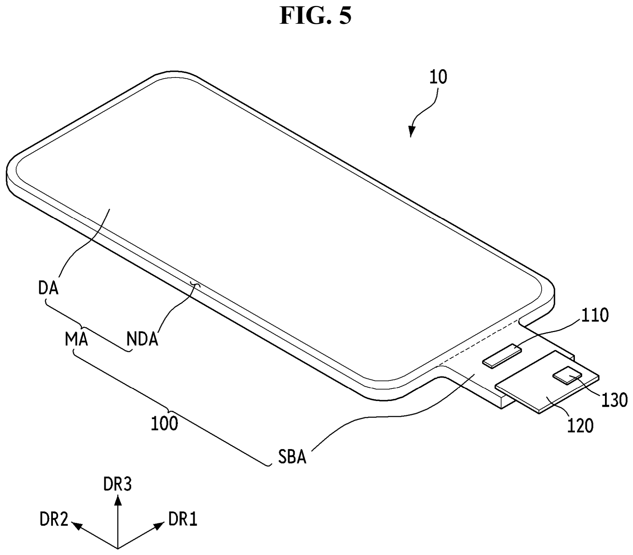

FIG. 5 is a perspective view showing the display device according to an embodiment of the present disclosure. For example, FIG. 5 shows the display panel 100 of the display device 10 and its peripheral elements.

Referring to FIG. 5, the display device 10 may provide a display screen where images are displayed in the electronic device 1. The display device 10 may have a shape similar to that of the electronic device 1 when viewed from the top. For example, in an embodiment the display device 10 may have a shape similar to a rectangle having shorter sides in the first direction DR1 and longer sides in the second direction DR2. In an embodiment, the corners where the shorter sides in the first direction DR1 meet the longer sides in the second direction DR2 may be rounded with a curvature. It should be understood, however, that embodiments of the present disclosure are not necessarily limited thereto. For example, the corners may be formed at a right angle. The shape of the display device 10 when viewed from the top is not necessarily limited to a quadrangular shape, but may be formed in a shape similar to other polygonal shapes, a circular shape, or an elliptical shape.

In an embodiment, the display device 10 may include a display panel 100, a display driver 110, a circuit board 120 and a touch driver 130.

The display panel 100 may include a main area MA and a subsidiary area SBA.

The main area MA may include the display area DA including pixels for displaying images, and the non-display area NDA located around the display area DA (e.g., in a plan view). The display area DA may output lights from a plurality of emission areas or a plurality of open areas. For example, the display panel 100 may include a pixel circuit including switching elements, a pixel-defining layer that defines the emission areas or the open areas, and self-light-emitting elements.

For example, the self-light-emitting element may include, but is not necessarily limited to, at least one of: an organic light-emitting diode including an organic emissive layer, a quantum-dot light-emitting diode (quantum LED) including a quantum-dot emissive layer, an inorganic light-emitting diode (inorganic LED) including an inorganic semiconductor, and a micro light-emitting diode (micro LED).

The non-display area NDA may be located on the outer side of the display area DA (e.g., in a plan view). The non-display area NDA may be defined as the edge area of the main area MA of the display panel 100. In an embodiment, the non-display area NDA may include a gate driver that applies gate signals to gate lines, and fan-out lines that connect the display driver 110 with the display area DA.

The subsidiary area SBA may be extended from one side of the main area MA. The subsidiary area SUB may include a flexible material that can be bent, folded, or rolled. For example, when the subsidiary area SBA is bent, the subsidiary area SBA may overlap the main area MA in the thickness direction (e.g., the third direction DR3). The subsidiary area SBA may include pads connected to the display driver 110 and the circuit board 120. According to an embodiment, the subsidiary area SBA may not be included in the display device 10, and the display driver 110 and the pads may be arranged in the non-display area NDA.

The display driver 110 may output signals and voltages for driving the display panel 100. The display driver 110 may supply data voltages to data lines. The display driver 110 may apply a supply voltage to a voltage line and may supply gate control signals to the gate driver. In an embodiment, the display driver 110 may be implemented as an integrated circuit (IC) and may be attached on the display panel 100 by a chip-on-glass (COG) technique, a chip-on-plastic (COP) technique, or ultrasonic bonding. For example, the display driver 110 may be located in the subsidiary area SBA and may overlap with the main area MA in the thickness direction (e.g., the third direction DR3) as the subsidiary area SBA is bent. For another example, the display driver 110 may be mounted on the circuit board 120.

In an embodiment, the circuit board 120 may be attached on the pad area of the display panel 100 using an anisotropic conductive film (ACF). Lead lines of the circuit board 120 may be electrically connected to the pads of the display panel 100. The circuit board 120 may be a flexible printed circuit board (FPCB), a printed circuit board (PCB), or a flexible film such as a chip-on-film (COF).

The touch driver 130 may be mounted on the circuit board 120. The touch driver 130 may be connected to a touch sensing unit of the display panel 100. The touch driver 130 may supply a touch driving signal to a plurality of touch electrodes of the touch sensing unit and may sense a change in the capacitance between the plurality of touch electrodes. For example, the touch driving signals may be pulse signals having a frequency. The touch driver 130 may determine whether there is an input and may find the coordinates of the input based on the amount of the change in the capacitance between the touch electrodes. The touch driver 130 may be implemented as an integrated circuit (IC).

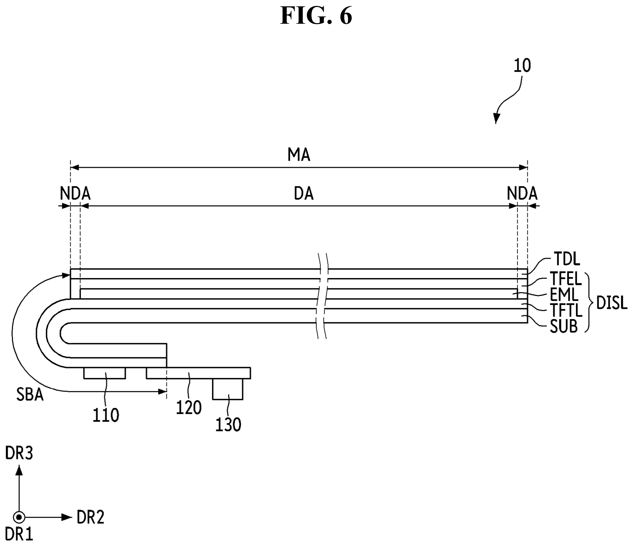

FIG. 6 is a cross-sectional view of the display device of FIG. 5 seen from the side.

Referring to FIG. 6, the display panel 100 may include a display layer DISL and a touch detecting layer TDL. In an embodiment, the display layer DISL may include a substrate SUB, a thin-film transistor layer TFTL, an emission material layer EML and an encapsulation layer TFEL.

The substrate SUB may be a base substrate or a base member. In an embodiment, the substrate SUB may be a flexible substrate that can be bent, folded, or rolled. For example, the substrate SUB may include, but is not necessarily limited to, a polymer resin such as polyimide PI. According to an embodiment, the substrate SUB may include a glass material or a metal material.

The thin-film transistor layer TFTL may be located on (e.g., disposed directly thereon) the substrate SUB. The thin-film transistor layer TFTL may include a plurality of thin-film transistors forming pixel circuits of pixels. The thin-film transistor layer TFTL may include gate lines, data lines, voltage lines, gate control lines, fan-out lines for connecting the display driver 110 with the data lines, lead lines for connecting the display driver 110 with the pads, etc. Each of the thin-film transistors may include a semiconductor region, a source electrode, a drain electrode, and a gate electrode. For example, in an embodiment in which the gate driver is formed on one side of the non-display area NDA of the display panel 100, the gate driver may include thin-film transistors.

The thin-film transistor layer TFTL may be located in the display area DA, the non-display area NDA and the subsidiary area SBA. The thin-film transistors in each of the pixels, the gate lines, the data lines and the voltage lines in the thin-film transistor layer TFTL may be located in the display area DA. The gate control lines and the fan-out lines in the thin-film transistor layer TFTL may be arranged in the non-display area NDA. The lead lines of the thin-film transistor layer TFTL may be arranged in the subsidiary area SBA.

The emission material layer EML may be located on (e.g., disposed directly thereon) the thin-film transistor layer TFTL. The emission material layer EML may include a plurality of light-emitting elements each including a pixel electrode, a common electrode and an emissive layer to emit light, and a pixel-defining film for defining the pixels. The plurality of light-emitting elements in the emission material layer EML may be arranged in the display area DA.

According to an embodiment of the present disclosure, the emissive layer may be an organic emissive layer containing an organic material. The emissive layer may include a hole transporting layer, an organic light-emitting layer and an electron transporting layer. When the pixel electrode receives a voltage and the common electrode receives a cathode voltage through the thin-film transistors in the thin-film transistor layer TFTL, the holes and electrons may move to the organic light-emitting layer through the hole transporting layer and the electron transporting layer, respectively, such that they combine in the organic light-emitting layer to emit light.

According to an embodiment, the light-emitting elements may include quantum-dot light-emitting diodes each including a quantum-dot emissive layer, inorganic light-emitting diodes each including an inorganic semiconductor, or micro light-emitting diodes.

An encapsulation layer TFEL may cover the upper and side surfaces of the emission material layer EML, and can protect the emission material layer EML. The encapsulation layer TFEL may include at least one inorganic film and at least one organic film for encapsulating the emission material layer EML.

The touch detecting layer TDL may be located on (e.g., disposed directly thereon) the encapsulation layer TFEL. The touch detecting layer TDL may include a plurality of touch electrodes for sensing a user's touch by capacitive sensing, and touch lines connecting the plurality of touch electrodes with the touch driver 130. For example, the touch detecting layer TDL may sense a user's touch by mutual capacitance sensing or self-capacitance sensing.

The plurality of touch electrodes of the touch detecting layer TDL may be located in a touch sensor area overlapping the display area DA. The touch lines of the touch detecting layer TDL may be located in a touch peripheral area overlapping the non-display area NDA.

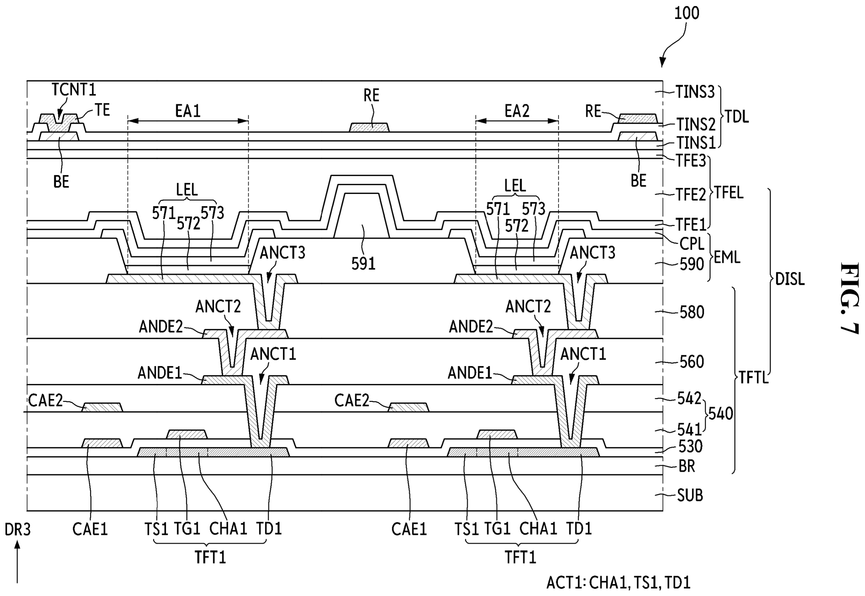

FIG. 7 is a schematic cross-sectional view of the display panel of FIG. 6.

Referring to FIG. 7, in an embodiment the display panel 100 may include a substrate SUB, a display layer DISL located on the substrate SUB, and a touch detecting layer TDL located on the display layer DISL. The display layer DISL may include a thin-film transistor layer TFTL, an emission material layer EML, and an encapsulation layer TFEL.

The thin-film transistor layer TFTL may be located on the substrate SUB (e.g., disposed directly thereon in the third direction DR3). In an embodiment, the thin-film transistor layer TFTL may include a barrier layer BR, a thin-film transistor TFT1, a first capacitor electrode CAE1, a second capacitor electrode CAE2, a first anode connection electrode ANDE1, a second anode connection electrode ANDE2, a gate insulator 530, a first interlayer dielectric layer 541, a second interlayer dielectric layer 542, a first planarization layer 560, a second planarization layer 580.

The substrate SUB may be made of an insulating material such as a polymer resin. For example, in an embodiment the substrate SUB may be made of polyimide. The substrate SUB may be a flexible substrate that can be bent, folded, or rolled.

A barrier layer BR may be located on the substrate SUB (e.g., disposed directly thereon in the third direction DR3). The barrier layer BR is a film for protecting the thin-film transistors of the thin-film transistor layer TFTL and an emissive layer 572 of the emission material layer EML. The barrier layer BR may be made up of multiple inorganic films stacked on one another alternately (e.g., in the third direction DR3). For example, in an embodiment the barrier layer BR may be made up of multiple layers in which one or more inorganic layers of a silicon nitride layer, a silicon oxynitride layer, a silicon oxide layer, a titanium oxide layer and an aluminum oxide layer are alternately stacked on one another (e.g., in the third direction DR3).

The thin-film transistor TFT1 may be located on the barrier layer BR (e.g., disposed directly thereon in the third direction DR3). An active layer ACT1 of the thin-film transistor TFT1 may be located on the barrier layer BR. In an embodiment, the active layer ACT1 of the thin-film transistor TFT1 may include polycrystalline silicon, monocrystalline silicon, low-temperature polycrystalline silicon, amorphous silicon, or an oxide semiconductor.

The active layer ACT1 may include a channel region CHA1, a source region TS1 and a drain region TD1. The channel region CHA1 may overlap with a gate electrode TG1 in the third direction DR3 that is the thickness direction of the substrate SUB. The source region TS1 may be located on one side of the channel region CHA1 (e.g., in a plan view), and the drain region TD1 may be located on the opposite side of the channel region CHA1 (e.g., in a plan view). The source region TS1 and the drain region TD1 may not overlap with the gate electrode TG1 in the third direction DR3. The source region TS1 and the drain region TD1 may be formed by doping a silicon semiconductor or an oxide semiconductor with ions or impurities to have conductivity.

The gate insulator 530 may be located on (e.g., disposed directly thereon) the active layer ACT1 of the thin-film transistor TFT1. In an embodiment, the gate insulator 530 may be formed of an inorganic layer, for example, a silicon nitride layer, a silicon oxynitride layer, a silicon oxide layer, a titanium oxide layer, or an aluminum oxide layer.

The gate electrode TG1 of the thin-film transistor TFT1 and the first capacitor electrode CAE1 may be located on the gate insulator 530 (e.g., disposed directly thereon in the third direction DR3). The gate electrode TG1 may overlap with the channel region CHA1 in the third direction DR3. Although the gate electrode TG1 and the first capacitor electrode CAE1 are spaced apart from each other in the example shown in FIG. 7, in some embodiments the gate electrode TG1 and the first capacitor electrode CAE1 may be connected with each other as a single piece. In an embodiment, the gate electrode TG1 and the first capacitor electrode CAE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first interlayer dielectric layer 541 may be located on the gate electrode TG1 of the thin-film transistor TFT1 and the first capacitor electrode CAE1. In an embodiment, the first interlayer dielectric layer 541 may be formed of an inorganic layer, for example, a silicon nitride layer, a silicon oxynitride layer, a silicon oxide layer, a titanium oxide layer, or an aluminum oxide layer. The first interlayer dielectric layer 541 may be made up of a plurality of inorganic films.

The second capacitor electrode CAE2 may be located on the first interlayer dielectric layer 541 (e.g., disposed directly thereon in the third direction DR3). The second capacitor electrode CAE2 may overlap the first capacitor electrode CAE1 of the thin-film transistor TFT1 in the third direction DR3. In addition, in an embodiment in which the gate electrode TG1 and the first capacitor electrode CAE1 are formed as a single piece, the second capacitor electrode CAE2 may overlap the gate electrode TG1 in the third direction DR3. Since the first interlayer dielectric layer 541 has a dielectric constant, a capacitor can be formed by the first capacitor electrode CAE1, the second capacitor electrode CAE2 and the first interlayer dielectric layer 541 between the electrodes. In an embodiment, the second capacitor electrode CAE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric layer 542 may be located over (e.g., directly thereon) the second capacitor electrode CAE2. In an embodiment, the second interlayer dielectric layer 542 may be formed of an inorganic layer, for example, a silicon nitride layer, a silicon oxynitride layer, a silicon oxide layer, a titanium oxide layer, or an aluminum oxide layer. The second interlayer dielectric layer 542 may be made up of a plurality of inorganic films.

A first anode connection electrode ANDE1 may be located on the second interlayer dielectric layer 542 (e.g., disposed directly thereon in the third direction DR3). In an embodiment, the first anode connection electrode ANDE1 may be connected to the drain electrode DT1 of the thin-film transistor TFT1 through a first connection contact hole ANCT1 that penetrates the gate insulator 530, the first interlayer dielectric layer 541 and the second interlayer dielectric layer 542. In an embodiment, the first anode connection electrode ANDE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first planarization layer 560 may be located over (e.g., disposed directly thereon) the first anode connection electrode ANDE1 for providing a flat surface over level differences due to the thin-film transistor TFT1. In an embodiment, the first planarization layer 560 may be formed of an organic layer such as an acryl resin, an epoxy resin, a phenolic resin, a polyamide resin and a polyimide resin.

In an embodiment, a second anode connection electrode ANDE2 may be located on the first planarization layer 560 (e.g., disposed directly thereon in the third direction DR3). The second anode connection electrode ANDE2 may be connected to the first anode connection electrode ANDE1 through a second connection contact hole ANCT2 penetrating the first planarization layer 560. In an embodiment, the second anode connection electrode ANDE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second planarization layer 580 may be located on the second anode connection electrode ANDE2 (e.g., disposed directly thereon in the third direction DR3). In an embodiment, the second planarization layer 180 may be formed of an organic layer such as an acryl resin, an epoxy resin, a phenolic resin, a polyamide resin and a polyimide resin.

An emission material layer EML including light-emitting elements LEL and a bank 590 may be located on the second planarization layer 580. Each of the light-emitting elements LEL includes a pixel electrode 571, an emissive layer 572, and a common electrode 573.

The pixel electrode 571 may be located on the second planarization layer 180 (e.g., disposed directly thereon in the third direction DR3). The pixel electrode 571 may be connected to the second anode connection electrode ANDE2 through a third connection contact hole ANCT3 penetrating the second planarization layer 580.

In the top-emission structure in which light exits from the emissive layer 572 towards the common electrode 573, the pixel electrode 571 may be made of a metal material having a high reflectivity such as a stack structure of aluminum and titanium (Ti / Al / Ti), a stack structure of aluminum (Al) and ITO (Indium Tin Oxide) (ITO/ Al /ITO), an APC alloy and a stack structure of an APC alloy and ITO (ITO / APC / ITO). The APC alloy is an alloy of silver (Ag), palladium (Pd) and copper (Cu).

The bank 590 may partition the pixel electrode 571 on the second planarization layer 580 to define the emission areas EA1 and EA2. The bank 590 may be located to cover the edges of the pixel electrode 571 and may expose a central portion of the pixel electrode 571. In an embodiment, the bank 590 may include an organic film such as an acryl resin, an epoxy resin, a phenolic resin, a polyamide resin and a polyimide resin.

In each of the first emission area EA1 and the second emission area EA2, the pixel electrode 571, the emissive layer 572 and the common electrode 573 are stacked on one another sequentially (e.g., in the third direction DR3), so that holes from the pixel electrode 571 and electrons from the common electrode 573 are recombined with each other in the emissive layer 572 to emit light.

The emissive layer 572 may be located on (e.g., disposed directly thereon) the pixel electrode 571 and the bank 590. The emissive layer 572 may include an organic material to emit light of a certain color. For example, in an embodiment the emissive layer 572 may include a hole transporting layer, an organic material layer, and an electron transporting layer.

The common electrode 573 may be located on the emissive layer 572. The common electrode 573 may cover the emissive layer 572. In an embodiment, the common electrode 573 may be a common layer formed commonly across the first emission area EA1 and the second emission area EA2.

In an embodiment, in the top-emission organic light-emitting diode, the common electrode 573 may include a transparent conductive material (TCP) such as ITO and IZO that can transmit light, or a semi-transmissive conductive material such as magnesium (Mg), silver (Ag) and an alloy of magnesium (Mg) and silver (Ag). When the common electrode 173 is made of a semi-transmissive metal material, the light extraction efficiency can be increased by using microcavities.

A spacer 591 may be located on the bank 590 (e.g., disposed directly thereon in the third direction DR3). In an embodiment, the spacer 591 may support a mask during a process of fabricating the emissive layer 572. In an embodiment, the spacer 591 may be implemented as an organic layer such as an acryl resin, an epoxy resin, a phenolic resin, a polyamide resin and a polyimide resin.

According to some embodiments of the present disclosure, the display panel 100 may further include a capping layer CPL located on the common electrode 573. The capping layer CPL may be made of an inorganic material. For example, in an embodiment the capping layer CPL may include at least one of: silicon nitride, aluminum nitride, zirconium nitride, titanium nitride, hafnium nitride, tantalum nitride, silicon oxide, aluminum oxide, titanium oxide, tin oxide, cerium oxide and silicon oxynitride.

An encapsulation layer TFEL may be located on the common electrode 573 (e.g., in the third direction DR3). The encapsulation layer TFEL may include at least one inorganic layer to prevent permeation of oxygen or moisture into the emission material layer EML. In addition, the encapsulation layer TFEL may include at least one organic film to protect the emission material layer EML from particles such as dust. For example, in an embodiment the encapsulation layer TFEL may include a first inorganic encapsulation layer TFE1, an organic encapsulation layer TFE2 and a second inorganic encapsulation layer TFE3.

The first inorganic encapsulation film TFE1 may be located on the common electrode 573 (e.g., in the third direction DR3), the organic encapsulation film TFE2 may be located on the first inorganic encapsulation film TFE1 (e.g., disposed directly thereon in the third direction DR3), and the second inorganic encapsulation film TFE3 may be located on the organic encapsulation film TFE2 (e.g., disposed directly thereon in the third direction DR3). The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another (e.g., in the third direction DR3). In an embodiment, the organic encapsulation film TFE2 may be an organic film such as an acryl resin, an epoxy resin, a phenolic resin, a polyamide resin, a polyimide resin, etc.

The touch detecting layer TDL may be located on the encapsulation layer TFEL (e.g., disposed directly thereon in the third direction DR3). In an embodiment, the touch detecting layer TDL includes a first touch insulating layer TINS1, bridge electrodes BE, a second touch insulating layer TINS2, the driving electrodes TE, the sensing electrodes RE, and a third touch insulating layer TINS3.

The first touch insulating layer TINS1 may be located on the encapsulation layer TFEL (e.g., disposed directly thereon in the third direction DR3). In an embodiment, the first touch insulating layer TINS1 may be implemented as an inorganic film, for example, a silicon nitride layer, a silicon oxynitride layer, a silicon oxide layer, a titanium oxide layer, or an aluminum oxide layer.

The bridge electrodes BE may be arranged on the first touch insulating layer TINS 1 (e.g., disposed directly thereon in the third direction DR3). In an embodiment, the bridge electrode BE may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second touch insulating layer TINS2 may be located over (e.g., disposed directly thereon) the bridge electrodes BE. In an embodiment, the second touch insulating layer TINS2 may be implemented as an inorganic layer, for example, a silicon nitride layer, a silicon oxynitride layer, a silicon oxide layer, a titanium oxide layer, or an aluminum oxide layer. Alternatively, the second touch insulating layer TINS2 may be made of an organic layer such as an acryl resin, an epoxy resin, a phenolic resin, a polyamide resin and a polyimide resin.

The driving electrodes TE and the sensing electrodes RE may be arranged on (e.g., disposed directly thereon) the second touch insulating layer TINS2. In an embodiment, the driving electrodes TE and the sensing electrodes RE may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The driving electrodes TE and the sensing electrodes RE may overlap with the bridge electrodes BE in the third direction DR3. The driving electrodes TE may be connected to the connection electrodes BE through touch contact holes TCNT1 penetrating through the first touch insulating layer TINS1.

The third touch insulating layer TINS3 may be formed on (e.g., disposed directly thereon) the driving electrodes TE and the sensing electrodes RE. The third touch insulating layer TINS3 may provide a flat surface over the driving electrodes TE, the sensing electrodes RE and the connection electrodes BE which have different heights from each other. In an embodiment, the third touch insulating layer TINS3 may be made of an organic layer such as an acryl resin, an epoxy resin, a phenolic resin, a polyamide resin and a polyimide resin.

Hereinafter, the window member 300, which is a main feature of the display device 10 according to an embodiment of the present disclosure will be described with reference to the accompanying drawings.

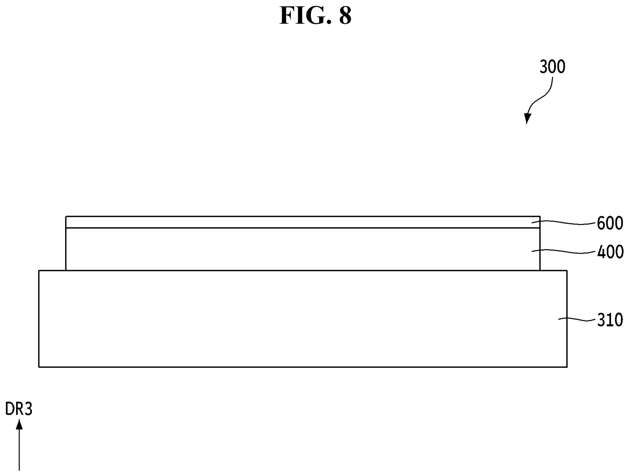

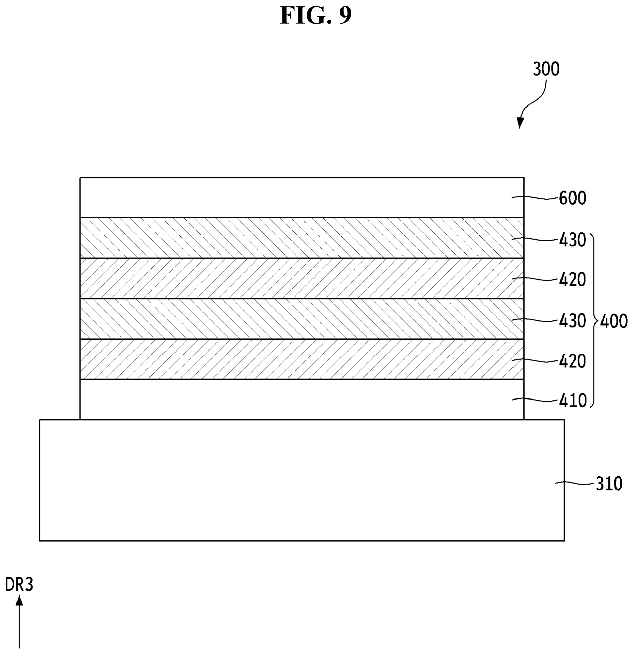

FIG. 8 is a cross-sectional view schematically showing a window member according to an embodiment. FIG. 9 is a cross-sectional view showing in detail the window member according to an embodiment.

Referring to FIGS. 8 and 9, the window member 300 may include a cover window 310, an optical member 400, and a functional member 600.

The cover window 310 can prevent the display panel 100 thereunder from being deformed by external impact, such as cracks, scratches and dents, and may form the base of the window member 300. The cover window 310 may contain a transparent material so that light from the display panel 100 can exit and be transmitted to the user. In an embodiment, the cover window 310 may include, such as glass or plastic.

In an embodiment, the thickness of the cover window 310 may be less than or equal to about 700 µm. A thickness of an element in the window member 300 may refer to the length of the element in the third direction DR3. For example, in an embodiment the thickness of the cover window 310 may be in a range from about 30 µm to about 700 µm. According to an embodiment, the cover window 310 may be ultra-thin glass (UTG) having a thickness in a range of about 30 µm to about 100 µm. According to an embodiment, the cover window 310 may be a glass substrate having a thickness in a range of about 400 µm to about 550 µm. According to an embodiment, the cover window 310 may be a transparent polymer film or plate having a thickness in a range of about 30 µm to about 700 µm. It should be understood, however, that embodiments of the present disclosure are not necessarily limited thereto. The thickness of the cover window 310 may vary within the range of about 30 µm to about 700 µm.

The optical member 400 may be disposed on the cover window 310. For example, in an embodiment the optical member 400 may be disposed directly on the upper surface of the cover window 310 (e.g., in the third direction DR3) and may be in direct contact with the upper surface of the cover window 310. The optical member 400 may reduce reflection of external light incident from the outside (e.g., the external environment).

In an embodiment, the optical member 400 may include a first refractive layer 410, a second refractive layer 420 and a third refractive layer 430 having different refractive indices from each other. In an embodiment, the second refractive layer 420 and the third refractive layer 430 may form a single group, and the optical member 400 may include a plurality of such groups each comprising the second refractive layer 420 and the third refractive layer 430. For example, when the optical member 400 includes a plurality of groups each consisting of a second refractive layer 420 and a third refractive layer 430 (e.g., at least two or more groups), the second refractive layer 420 and the third refractive layer 430 may be stacked on each other alternately (e.g., in the third direction DR3). In the example shown in FIG. 9, two groups each including a second refractive layer 420 and a third refractive layer 430 are sequentially stacked on the first refractive layer 410 (e.g., in the third direction DR3). However, in some embodiments three or more groups each including a second refractive layer 420 and a third refractive layer 430 may be sequentially stacked on the first refractive layer 410 (e.g., in the third direction DR3).

In an embodiment, the first refractive layer 410 may be located on the cover window 310 (e.g., disposed directly thereon in the third direction DR3). For example, the first refractive layer 410 may be disposed directly on the upper surface of the cover window 310 and may be in direct contact with the upper surface of the cover window 310. According to an embodiment, the first refractive layer 410 may be formed on the cover window 310 by vacuum deposition, and may be formed directly on the upper surface of the cover window 310. Accordingly, the adhesion between the first refractive layer 410 and the cover window 310 can be increased.

In an embodiment, the first refractive layer 410 may have a refractive index (e.g., a first refractive index) between the refractive index (e.g., a second refractive index) of the second refractive layer 420 and the refractive index (e.g., a third refractive index) of the third refractive layer 430. For example, in an embodiment the refractive index of the first refractive layer 410 may be less than the refractive index of the second refractive layer 420 and larger than the refractive index of the third refractive layer 430. When the first refractive layer 410 has a refractive index between the refractive index of the second refractive layer 420 and the refractive index of the third refractive layer 430, the amount of reflected external light incident from the outside (e.g., the external environment) can be reduced since the difference in refractive index at the interface between the second refractive layer 420 and the first refractive layer 410 is small. For example, the reflectance of external light can be reduced at the interface between the first refractive layer 410 and the second refractive layer 420.

In an embodiment, the first refractive layer 410 may have a refractive index (e.g., a first refractive index) between the refractive index (e.g., a fourth refractive index) of the cover window 310 and the refractive index (e.g., a second refractive index) of the second refractive layer 420. For example, in an embodiment the refractive index (e.g., a first refractive index) of the first refractive layer 410 may be greater than the refractive index (e.g., a fourth refractive index) of the cover window 310 and less than the refractive index (e.g., a second refractive index) of the second refractive layer 420. In an embodiment in which the first refractive layer 410 has a refractive index between the refractive index of the cover window 310 and the refractive index of the second refractive layer 420, the amount of reflected external light incident from the outside can be reduced since the difference in refractive index at the interface between the cover window 310 and the first refractive layer 410 is small. For example, the reflectance of external light can be reduced at the interface between the cover window 310 and the first refractive layer 410.

In an embodiment, the refractive index (e.g., a first refractive index) of the first refractive layer 410 may be in a range from about 1.4 to about 1.9. For example, in an embodiment the refractive index of the first refractive layer 410 may be in a range from about 1.7 to about 1.8. It should be understood, however, that embodiments of the present disclosure are not necessarily limited thereto. The refractive index of the first refractive layer 410 may be variously adjusted within the range of 1.4 to 1.9.

The first refractive layer 410 may at least include silicon (Si). For example, in an embodiment the first refractive layer 410 may include an oxide containing silicon, an oxynitride containing at least silicon, or a nitride including silicon. For example, the oxide containing silicon may be silicon oxide (SiO₂), the oxynitride containing silicon may be silicon nitride (SiON), and the nitride containing silicon may be silicon nitride (SiNx).

According to an embodiment of the present disclosure, the first refractive layer 410 may be oxynitride containing silicon. For example, the first refractive layer 410 may be silicon nitride (SiON). In an embodiment in which the first refractive layer 410 is made of silicon nitride, the content of silicon (Si) may be in a range of about 10 at% to about 50 at%, the content of oxygen (O₂) may be less than about 50 at%, and the content of nitrogen (N) may be the rest excluding the contents of silicon and oxygen. In the first refractive layer 410, as the content of nitrogen increases, the refractive index increases, and as the content of oxygen increases, the refractive index decreases. Accordingly, the contents of silicon, oxygen and nitrogen may be variously adjusted within the content ranges of the elements described above.

In an embodiment, the first refractive layer 410 may further include a metal. For example, the first refractive layer 410 may include silicon and may further include a metal. In an embodiment, the metal may be aluminum (Al). For example, in an embodiment, the first refractive layer 410 may include oxynitride containing silicon and aluminum, oxynitride containing silicon and aluminum, or nitride containing silicon and aluminum. For example, the nitride containing silicon and aluminum may be aluminum silicon nitride (AlSiON). In an embodiment in which the first refractive layer 410 contains aluminum, the hardness of the first refractive layer 410 can be increased, thereby preventing warpage of the optical member 400.

According to an embodiment of the present disclosure, the first refractive layer 410 may be aluminum silicon nitride (AlSiON). In an embodiment in which the first refractive layer 410 is made of aluminum silicon nitride, the sum of the content of aluminum (Al) and the content of silicon (Si) may be in a range of about 10 at% to about 50 at%, the content of oxygen (O₂) may be less than about 50 at%, and the content of nitrogen (N) may be the rest (e.g., the remainder) excluding the contents of aluminum, silicon, and oxygen.

The first refractive layer 410 may have a thickness for reducing light reflectance at the interface between the cover window 310 and the first refractive layer 410, and at the interface between the first refractive layer 410 and the second refractive layer 420. In an embodiment, the thickness of the first refractive layer 410 may be in the range of about 10% to about 40% with respect to the total thickness of the optical member 400. In addition, the thickness of the first refractive layer 410 may be in the range of about 75% to about 95% of the thickness of the third refractive layer 430 disposed at the uppermost layer of the optical member 400. For example, in an embodiment the thickness of the first refractive layer 410 may be in the range of about 40 nm to about 150 nm according to an optical design of λ/8 to λ/2.

The second refractive layer 420 may be located on the first refractive layer 410 (e.g., in the third direction DR3). For example, the second refractive layer 420 may be disposed directly on the upper surface of the first refractive layer 410 (e.g., in the third direction DR3) and may be in direct contact with the first refractive layer 410. According to an embodiment, the second refractive layer 420 may be formed on the first refractive layer 410 by vacuum deposition, and may be formed directly on the upper surface of the first refractive layer 410. Accordingly, the adhesion between the first refractive layer 410 and the second refractive layer 420 can be increased. The second refractive layer 420 may be spaced apart from the cover window 310 with the first refractive layer 410 between the second refractive layer 420 and the cover window 310 (e.g., in the third direction DR3). For example, the second refractive layer 420 may not be in direct contact with the cover window 310.

In an embodiment, the second refractive layer 420 may have the highest refractive index in the optical member 400. For example, the refractive index of the second refractive layer 420 (e.g., a second refractive index) may be greater than the refractive index of the first refractive layer 410 and the refractive index of the third refractive layer 430. In an embodiment in which the refractive index (e.g., a second refractive index) of the second refractive layer 420 is greater than the refractive index (e.g., a first refractive index) of the first refractive layer 410 and the refractive index (e.g., a third refractive index) of the third refractive layer 430, the amount of reflected external light can be reduced because the difference in refractive indexes at the interface between the second refractive layer 420 and the first refractive layer 410 and the interface between the second refractive layer 420 and the third refractive layer 430 is small. For example, the reflectance of external light can be reduced at the interface between the first refractive layer 410 and the second refractive layer 420 and the interface between the second refractive layer 420 and the third refractive layer 430.

In an embodiment, the refractive index (e.g., a second refractive index) of the second refractive layer 420 may be in a range of about 1.9 to about 2.3. For example, the refractive index of the second refractive layer 420 may be in a range of about 2.0 to about 2.1. It should be understood, however, that embodiments of the present disclosure are not necessarily limited thereto. The refractive index of the second refractive layer 420 may be variously adjusted within the range of about 1.9 to about 2.3.

In an embodiment, the second refractive layer 420 may include at least one of silicon (Si) and a metal. For example, the second refractive layer 420 may include one of: an oxide containing silicon, an oxynitride containing silicon, a nitride containing silicon, an oxide containing metal, an oxynitride containing metal, a nitride containing metal, an oxide containing silicon and metal, an oxynitride containing silicon and metal, a nitride containing silicon and metal. According to an embodiment of the present disclosure, the second refractive layer 420 may be one of: silicon oxynitride (SiON), silicon nitride (SiNx), aluminum oxynitride (AlON), aluminum nitride (AlN), aluminum silicon oxynitride (AlSiON), aluminum silicon nitride (AlSiN), tantalum oxide (Ta₂O₅), niobium oxide (Nb₂O₅), hafnium oxide (HfO₂), titanium oxide (TiO₂), zirconium oxide (ZrO₂), yttrium oxide (Y₂O₃), aluminum oxide (Al₂O₃), and molybdenum oxide (MoO₃).

According to an embodiment of the present disclosure, the second refractive layer 420 may be a nitride containing silicon. In an embodiment, the second refractive layer 420 may be a nitride containing silicon and a metal. For example, the second refractive layer 420 may be aluminum silicon nitride (AlSiN). In an embodiment in which the second refractive layer 420 is made of aluminum silicon nitride, the sum of the content of aluminum and the content of silicon may be less than or equal to about 90 at%, such as in a range of about 10 at% to about 90 at%. For example, in an embodiment, if the sum of the content of aluminum and the content of silicon is 90 at%, the content of aluminum may be x at% while the content of silicon may be 90-x at%. The content of nitrogen (N) in the second refractive layer 420 may be the rest (e.g., the remainder) excluding the content of silicon and the content of aluminum. The second refractive layer 420 contains aluminum, so that the hardness of the second refractive layer 420 can be increased, thereby preventing warpage of the optical member 400.

The second refractive layer 420 may have a thickness that can reduce the reflectance by causing destructive interference between light reflected from the upper surface of the third refractive layer 430 and light reflected at the interface between the second refractive layer 430 and the third refractive layer 430. In an embodiment, the thickness of each of the second refractive layers 420 may be in a range of about 130% to about 240% of the thickness of the third refractive layer 430 disposed at the uppermost layer of the optical member 400. For example, in an embodiment the thickness of the second refractive layer 420 may be in the range of about 100 nm to about 190 nm according to an optical design of λ/2.

The third refractive layer 430 may be located on the second refractive layer 420 (e.g., disposed directly thereon in the third direction DR3). For example, the third refractive layer 430 may be disposed directly on the upper surface of the second refractive layer 420 and may be in direct contact with the second refractive layer 420. According to an embodiment, the third refractive layer 430 may be formed on the second refractive layer 420 by vacuum deposition, and may be formed directly on the upper surface of the second refractive layer 420 (e.g., in the third direction DR3). Accordingly, the adhesion between the second refractive layer 420 and the third refractive layer 430 can be increased. In an embodiment, the third refractive layer 430 may be spaced apart from the cover window 310 with the first refractive layer 410 and the second refractive layer 420 between the third refractive layer 430 and the cover window 310 (e.g., in the third direction DR3). For example, the third refractive layer 430 may not be in direct contact with an upper surface of the cover window 310 and may be spaced apart from the upper surface of the cover window 310.

The third refractive layer 430 may have the lowest refractive index in the optical member 400. For example, the refractive index (e.g., a third refractive index) of the third refractive layer 430 may be lower than the refractive index (e.g., a first refractive index) of the first refractive layer 410 and the refractive index (e.g., a second refractive index) of the second refractive layer 420. If the refractive index of the third refractive layer 430 is less than the refractive index of the first refractive layer 410 and the refractive index of the second refractive layer 420, the amount of reflected external light incident from the outside can be reduced since the difference in refractive index at the interface between the second refractive layer 420 and the first refractive layer 430 is small. For example, the reflectance of external light can be reduced at the interface between the second refractive layer 420 and the third refractive layer 430.

The refractive index of the third refractive layer 430 may be less than about 1.5. For example, in an embodiment the refractive index of the third refractive layer 430 may be in a range of about 1.3 to about 1.5. It should be understood, however, that embodiments of the present disclosure are not necessarily limited thereto. The refractive index of the third refractive layer 430 may be variously adjusted within the range of about 1.3 to about 1.5.

The third refractive layer 430 may include at least one of silicon (Si) and a metal. For example, in an embodiment the third refractive layer 430 may include one of: an oxide containing silicon, an oxynitride containing silicon, nitride containing silicon, an oxide containing metal, an oxynitride containing metal, a nitride containing metal, an oxide containing silicon and metal, an oxynitride containing silicon and metal, a nitride containing silicon and metal. According to an embodiment of the present disclosure, the third refractive layer 430 may include one of silicon nitride (SiON), aluminum nitride (AlON), aluminum silicon nitride (AlSiON), silicon oxide (SiO₂), aluminum oxide (Al₂O₃), germanium oxide (GeO₂), and magnesium oxide (MgO). According to an embodiment of the present disclosure, the third refractive layer 430 may be an oxide containing silicon. For example, the third refractive layer 430 may be silicon oxide (SiO₂).

The third refractive layer 430 may have such a thickness that can reduce the reflectance by causing destructive interference between light reflected from the upper surface of the third refractive layer 430 and light reflected at the interface between the second refractive layer 430 and the third refractive layer 430. In an embodiment, the thickness of each third refractive layer 430 may be in a range of about 1% to about 30% of the total thickness of the optical member 400. For example, the thickness of the third refractive layer 430 may be in the range of about 10 nm to about 100 nm according to an optical design of λ/4.

According to an embodiment of the present disclosure, the third refractive layer 430 may be located at the top of the optical member 400 (e.g., an uppermost layer of the optical member 400) and between the second refractive layers 420. In an embodiment, the thickness of the third refractive layer 430 at the top of the optical member 400 comprising an uppermost layer of the optical member 400 may be greater than the thickness of the third refractive layer 430 located between the second refractive layers 420. For example, in an embodiment the thickness of the third refractive layer 430 at the top of the optical member 400 may be in a range of about 80% to about 90% of the sum of the thicknesses of all third refractive layers 430 included in the optical member 400. Accordingly, the third refractive layer 430 at the top of the optical member 400 can reduce the reflection of the external light by causing destructive interference between light reflected from the upper surface of the third refractive layer 430 and light reflected at the interface between the third refractive layer 430 and the second refractive layer 420.

According to an embodiment of the present disclosure, the thicknesses of the first refractive layer 410 and the second refractive layers 420 with respect to the total thickness of the optical member 400 may be in a range of about 70% to about 90%. The first refractive layer 410 and the second refractive layers 420 may include materials having higher hardness and refractive index than the third refractive layer 430, thereby increasing the hardness of the entire optical member 400 or the window member 300.

In addition, as shown in FIG. 9, in an embodiment, in the optical member 400, a first group of a second refractive layer 420 and a third refractive layer 430 may be arranged on the first refractive layer 410, and a second group of a second refractive layer 420 and a third refractive layer 430 may be arranged on the first group (e.g., disposed directly thereon in the third direction DR3). According to an embodiment of the present disclosure, the ratio of the thickness of the second group to the thickness of the first group may be in a range of about 0.8 to about 1.5, and the ratio of the thickness of the second group to the sum of the thickness of the first group and the thickness of the first refractive layer 410 may be in a range of about 0.6 to about 1.1.

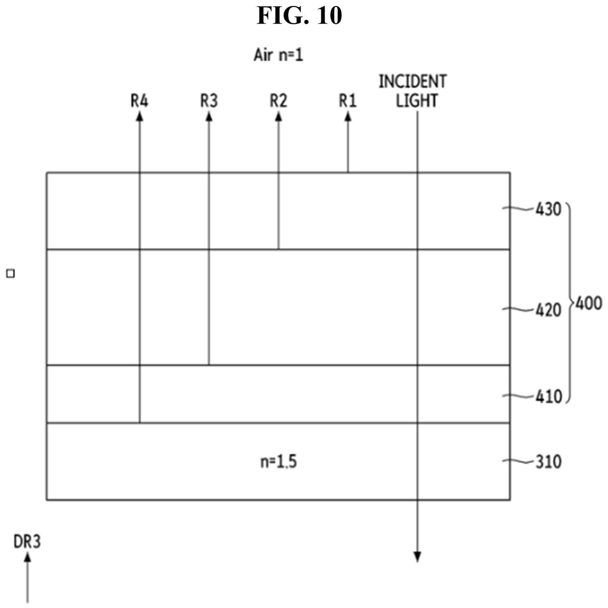

FIG. 10 is a view schematically showing an optical member according to an embodiment of the present disclosure. In the schematic view of FIG. 10 for illustrating the reflection of light in the optical member, one first refractive layer 410, one second refractive layer 420 and one third refractive layer 430 are depicted for economy of explanation.

Referring to FIG. 10, when light is incident from the outside onto the optical member 400 (Incident Light in FIG. 10), the light may be reflected at the upper surface of the third refractive layer 430, the interface between the third refractive layer 430 and the second refractive layer 420, the interface between the second refractive layer 420 and the first refractive layer 410, and the interface between the first refractive layer 410 and the cover window 310.

In an embodiment, the second refractive layer 420 having a lower refractive index and the third refractive layer 430 having a higher refractive index are designed with such thicknesses that causes destructive interference between a reflected light R1 reflected from the upper surface of the third refractive layer 430 and a reflected light R2 reflected at the interface between the third refractive layer 430 and the second refractive layer 420, thereby reducing the reflection of external light. The first refractive layer 410 having a medium refractive index (e.g., a refractive index between the high refractive index and the low refractive index) is arranged between the cover window 310 and the second refractive layer 420, so that the difference in refractive index at the interface between the second refractive layer 420 and the first refractive layer 410 and the difference in refractive index at the interface between the first refractive layer 410 and the cover window 310 can be reduced. Accordingly, the amount of reflection of a reflected light R3 reflected at the interface between the second refractive layer 420 and the first refractive layer 410 and a reflected light R4 reflected at the interface between the first refractive layer 410 and the cover window 310 can be reduced, so that reflection at each of the interfaces can be reduced.

In the optical member 400 described above, the second refractive layer 420 having a higher refractive index and the third refractive layer 430 having a lower refractive index are stacked on one another alternately (e.g., in the third direction DR3), and the first refractive layer 410 having a medium refractive index is located between the cover window 310 and the second refractive layer 420, so that the reflectance of external light can be reduced. In addition, by including a metal, such as aluminum, in the second refractive layer 420, the hardness of the optical member 400 can be increased, thereby preventing warpage. In addition, by including a metal, such as aluminum, in the first refractive layer 410, the hardness of the optical member 400 can be further increased, thereby further preventing warpage.

Referring back to FIG. 9, the functional member 600 may be disposed on the optical member 400. In an embodiment, the functional member 600 may be formed directly on the optical member 400 (e.g., in the third direction DR3) and may be in direct contact with the upper surface of the optical member 400. For example, the functional member 600 may be in direct contact with the upper surface of the third refractive layer 430 forming the uppermost portion of the optical member 400.

In an embodiment, the functional member 600 may include at least one of an anti-fingerprint layer, an anti-glare layer, an anti-scattering layer, a shock-absorbing layer, and an anti-scratch layer. According to an embodiment of the present disclosure, the functional member 600 may be an anti-fingerprint layer having the anti-fingerprint function. In an embodiment, the anti-fingerprint layer may include one or more of polyimide, polycarbonate, polyethersulfone, polyethylene naphthalate, polyphenylene sulfide, and polymethyl methacrylate. According to an embodiment of the present disclosure, the anti-fingerprint layer may further contain fluorine. According to an embodiment, the anti-fingerprint layer may include a fluorine polymer.

In an embodiment, the functional member 600 may be fabricated by spraying or coating one of the above-listed materials in liquid phase and then drying it. In an embodiment, the thickness of the functional member 600 may be in a range from about 1 nm to about 1,000 nm. According to an embodiment, when the functional member 600 is an anti-fingerprint layer, the thickness of the anti-fingerprint layer may be in a range of about 1 nm to about 10 nm. The functional member 600 may have a refractive index similar to or equal to that of the third refractive layer 430 in direct contact with the functional member 600. For example, in an embodiment the refractive index of the functional member 600 may be in a range of about 1.3 to about 1.5, such as about 1.4 to about 1.5. According to an embodiment of the present disclosure, the refractive index of the functional member 600 may be equal to that of the third refractive layer 430.

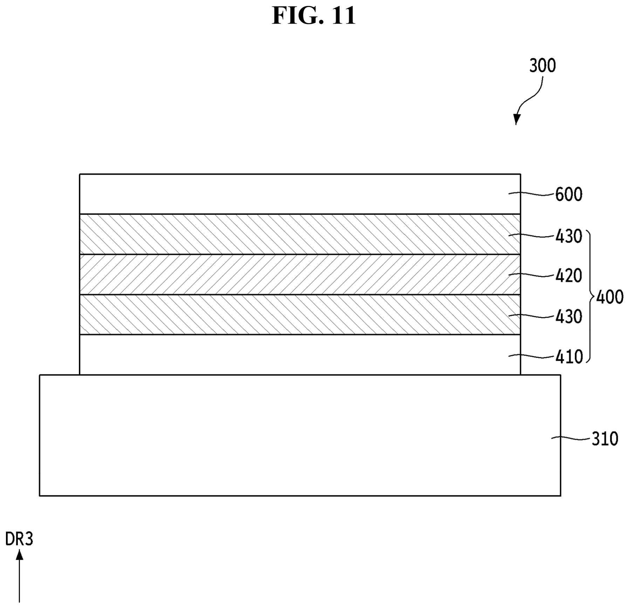

FIG. 11 is a cross-sectional view schematically showing a window member according to an embodiment.

An optical member 400 according to an embodiment of FIG. 11 is different from that of the above-described embodiment of FIG. 9 in that a second refractive layer 420 is not included between a first refractive layer 410 and a third refractive layer 430. The following description will focus on the difference and the redundant descriptions will be omitted for economy of explanation.

In an embodiment, in the optical member 400, a first refractive layer 410, a third refractive layer 430, a second refractive layer 420 and a third refractive layer 430 may be sequentially stacked on the cover window 310 (e.g., in the third direction DR3). For example, the optical member 400 may include a first refractive layer 410 disposed directly on the cover window 310, a third refractive layer 430 disposed directly on the first refractive layer 410 and at least one group including a second refractive layer 420 and a third refractive layer 430 alternately stacked (e.g., in the third direction DR3) disposed directly on the third refractive layer 430. While an embodiment shown in FIG. 11 includes only one group of the alternately stacked second and third refractive layers 420, 430, embodiments of the present disclosure are not necessarily limited thereto and the number of groups may be two or more in some embodiments.

According to this embodiment, the total number of the layers of the optical member 400 is four, which is one fewer as compared to an embodiment shown in FIG. 9. As a result, the thickness can be reduced. In an embodiments in which the total number of groups may be two or more, the total number of layers will still be one fewer which will also result in a reduction of the thickness. The first refractive layer 410 located directly on the cover window 310 may have a refractive index between the refractive index of the third refractive layer 430 and the refractive index of the second refractive layer 420. For example, in an embodiment the first refractive layer 410 may have a refractive index (e.g., a first refractive index) that is less than a refractive index (e.g., a third refractive index) of the third refractive layer 430 and greater than a refractive index (e.g., a second refractive index) of the second refractive layer 420. The first refractive layer 410 may lower the difference in refractive index at the interface with the cover window 310 and may lower the difference in refractive index at the interface with the third refractive layer 430. Accordingly, the amount of light reflected at the interface between the first refractive layer 410 and the cover window 310 can be reduced. In addition, the first refractive layer 410 may also perform the function of the second refractive layer 420 of FIG. 9 that is not included, thereby reducing the amount of light reflected at the interface between the first refractive layer 410 and the third refractive layer 430.

According to this embodiment, the first refractive layer 410 additionally performs the function of the second refractive layer 420, the total number of the layers of the optical member 400 can be reduced. Accordingly, the thickness of the optical member 400 can be reduced, and the fabrication cost can be reduced by omitting the process.

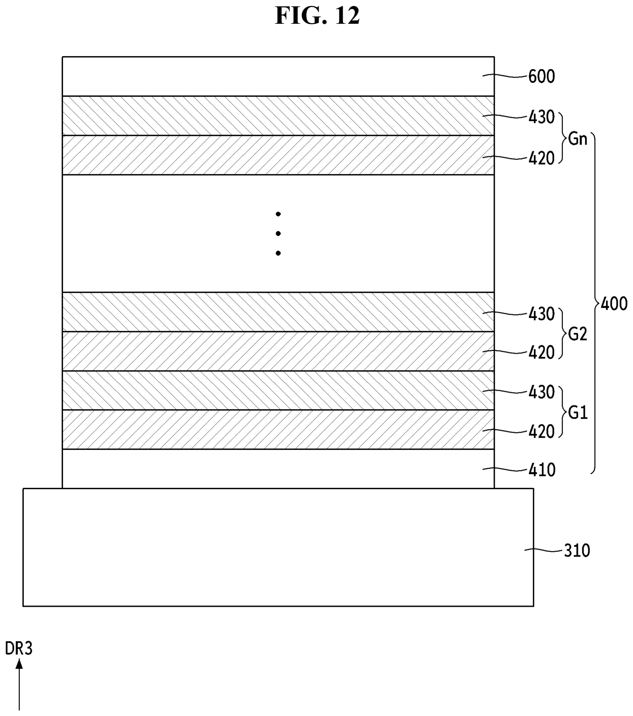

FIG. 12 is a cross-sectional view schematically showing a window member according to an embodiment.

An optical member 400 according to an embodiment of FIG. 12 is different from the above-described embodiments in that a second refractive layer 420 and a third refractive layer 430 may form a single group, and the optical member 400 may include three or more of such groups.

In an embodiment, the optical member 400 may be disposed on the cover window 310 (e.g., disposed directly thereon in the third direction DR3). The optical member 400 may include a plurality of groups Gn each consisting of a second refractive layer 420 and a third refractive layer 430, together with the first refractive layer 410. For example, the first refractive layer 410 may be disposed on the cover window 310 (e.g., disposed directly thereon in the third direction DR3). A plurality of groups each consisting of a second refractive layer 420 and a third refractive layer 430 may be provided on the first refractive layer 410. For example, in an embodiment a first group G1 of a second refractive layer 420 and a third refractive layer 430 may be arranged on the first refractive layer 410 (e.g., disposed directly thereon in the third direction DR3), and a second group G2 of a second refractive layer 420 and a third refractive layer 430 may be arranged on the first group G1 (e.g., sequentially disposed directly thereon in the third direction DR3). The n^{th} group Gn may be arranged on the second group G2 (e.g., disposed directly thereon in the third direction DR3), where n is a natural number greater than or equal to 3.

According to an embodiment of the present disclosure, the optical member 400 may include three or more groups Gn of second refractive layers 420 and third refractive layers 430 depending on the device employing the window member 300 or desired optical properties. The functional member 600 may be arranged on the optical member 400 (e.g., disposed directly thereon in the third direction DR3).

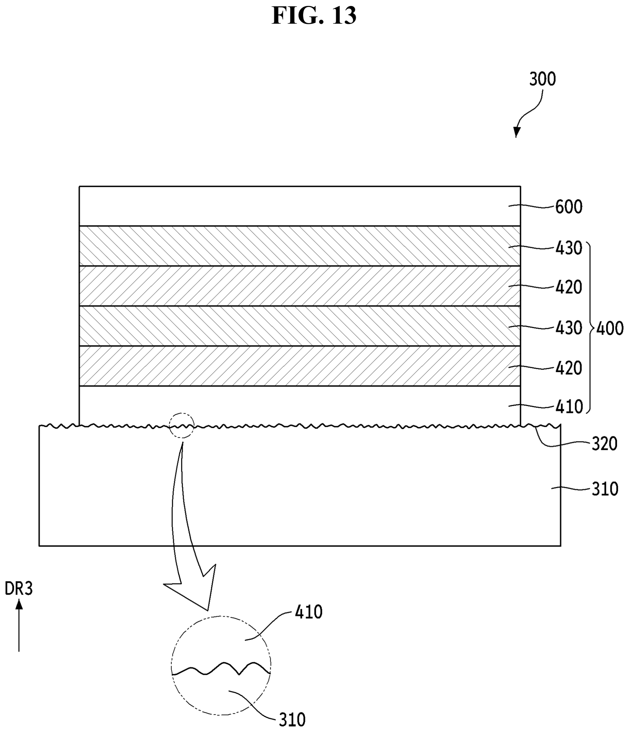

FIG. 13 is a cross-sectional view schematically showing a window member according to an embodiment.

The embodiment of FIG. 13 is different from the above-described embodiments in that the upper surface of the cover window 310 includes a rough structure 320. Although the structure of the embodiment of FIG. 9 is illustrated in FIG. 13 as an example, it is to be understood that embodiments of the present disclosure are not necessarily limited thereto. The rough structure 320 of the cover window 310 may also be applied to embodiments shown in FIGS. 11 and 12.

The cover window 310 may include the rough structure 320. For example, the rough structure 320 may be formed on the upper surface of the cover window 310 facing the first refractive layer 410 and may have an uneven, rough surface. The rough structure 320 may form the upper surface of the cover window 310 and may be in direct contact with the first refractive layer 410 of the optical member 400.

The rough structure 320 may be arranged randomly. For example, in an embodiment the size, pitch or height of the protrusions of the rough structure 320 may be random, and the shape of the protrusions may also be random.

The rough structure 320 may reflect and scatter incident light from the outside to cause destructive interference. For example, incident light may be reflected and scattered between the protrusions of the rough structure 320 and may be subject to destructive interference. Accordingly, the upper surface of the cover window 310 having the rough structure 320 can reduce reflection of external light. For example, in an embodiment the straight reflectance of the cover window 310 with the rough structure 320 may be less than or equal to about 0.1%, and the scattered reflectance may be less than or equal to about 0.9%.

Hereinafter, Examples and Experimental Examples according to the above-described embodiments will be described. It should be noted that embodiments of the present disclosure are not necessarily limited thereto.

### < Example: Fabrication of Window Member >

### Comparative Example 1

A glass substrate having the thickness of 400 µm was prepared for Comparative Example 1.

### Comparative Example 2

A SiO₂ layer having the thickness of 8 nm, a SiNx layer having the thickness of 100 nm, a SiO₂ layer having the thickness of 20 nm, a SiNx layer having the thickness of 20 nm, and a SiO₂ layer having the thickness of 20 nm were stacked on the glass substrate having the thickness of 400 µm, and then an anti-fingerprint layer having the thickness of 5 nm was stacked to fabricate a window member of Comparative Example 2.

### Example 1

A SiON layer having the thickness of 68 nm, a AlSiN layer having the thickness of 135 nm, a SiO₂ layer having the thickness of 13 nm, a AlSiN layer having the thickness of 142 nm, and a SiO₂ layer having the thickness of 77 nm were stacked on the glass substrate having the thickness of 400 µm, and then an anti-fingerprint layer having the thickness of 5 nm was stacked to fabricate a window member of Example 1.

### Example 2

A SiON layer having the thickness of 73 nm, a AlSiN layer having the thickness of 170 nm, a SiO₂ layer having the thickness of 13 nm, a AlSiN layer having the thickness of 153 nm, and a SiO₂ layer having the thickness of 81 nm were stacked on the glass substrate having the thickness of 400 µm, and then an anti-fingerprint layer having the thickness of 5 nm was stacked to fabricate a window member of Example 2.

### Example 3

A SiON layer having the thickness of 45 nm, a SiO₂ layer having the thickness of 12 nm, a AlSiN layer having the thickness of 268 nm, and a SiO₂ layer having the thickness of 81 nm were stacked on the glass substrate having the thickness of 400 µm, and then an anti-fingerprint layer having the thickness of 5 nm was stacked to fabricate a window member of Example 3.

In Examples 1 to 3, the refractive index of the SiON layer was approximately 1.72, the refractive index of the AlSiN layer was approximately 2.02, the refractive index of the SiO₂ layer was approximately 1.46, and the refractive index of the anti-fingerprint layer was approximately 1.46.

### < Experimental Example 1: Measurement of Transmittance and Reflectance of Window Member >

The transmittance and the reflectance of the window members fabricated according to Comparative Example 1, Comparative Example 2, Example 1, Example 2 and Example 3 described above were measured. Transmittance and reflectance were measured using a CM-3700A spectrophotometer commercially available from Minolta Co., Ltd.

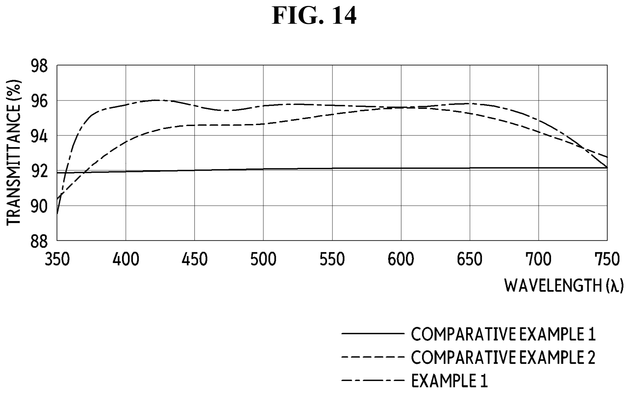

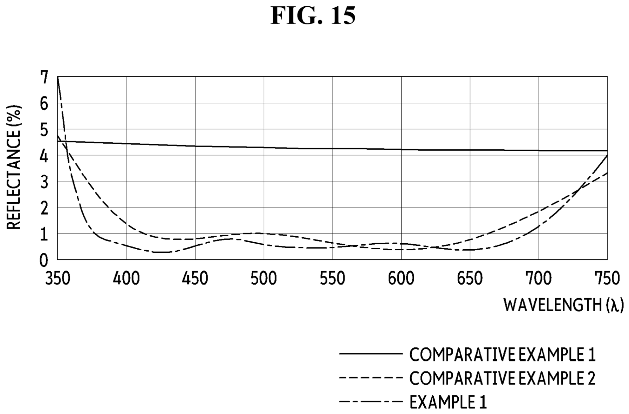

FIG. 14 is a graph showing the transmittance according to the wavelength of window members fabricated according to Comparative Example 1, Comparative Example 2, and Example 1. FIG. 15 is a graph showing the reflectance according to the wavelength of window members fabricated according to Comparative Example 1, Comparative Example 2, and Example 1.

Referring to FIG. 14, the transmittance of the window member according to Example 1 was found to be superior to the transmittance of the window members according to Comparative Examples 1 and 2. In particular, in the wavelength range of 350 to 550 nm, the transmittance of the window member according to Example 1 was significantly higher than the transmittance of the window member according to Comparative Example 2.

Referring to FIG. 15, the reflectance of the window member according to Example 1 was found to be superior to (e.g., less than) the reflectance of the window members according to Comparative Examples 1 and 2. In particular, in the wavelength range of 350 to 550 nm, the reflectance of the window member according to Example 1 was significantly lower than the reflectance of the window member according to Comparative Example 2.

It can be seen from these results that in the window member according to Example 1 having the SiON layer with a medium refractive index between the glass substrate and the AlSiN layer having a high refractive index the reflectance was lowered and transmittance was increased. In particular, when ultraviolet (UV) light is irradiated to cure the adhesive member 200 that adheres the display panel 100 with the window member 300, the light transmittance of the window member 300 for the UV wavelength range is excellent, and thus it is possible to prevent incomplete curing of the adhesive member 200.

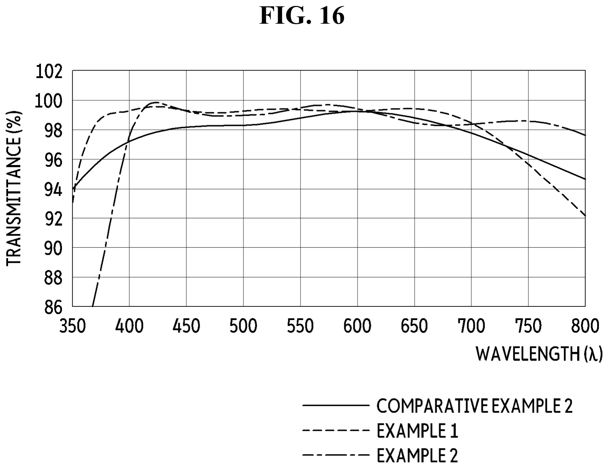

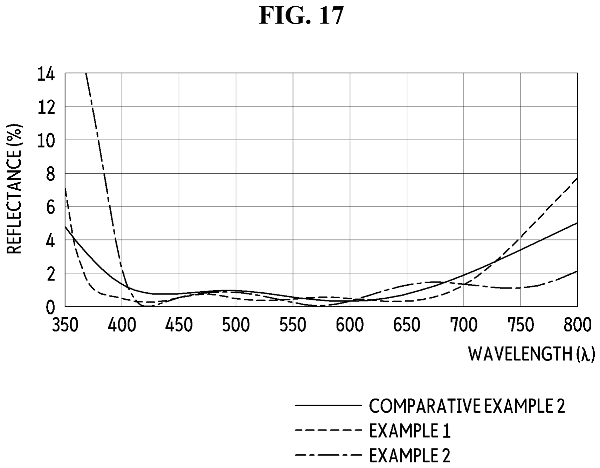

FIG. 16 is a graph showing the transmittance according to the wavelength of window members fabricated according to Comparative Example 2, Example 1, and Example 2. FIG. 17 is a graph showing the reflectance according to the wavelength of window members fabricated according to Comparative Example 2, Example 1, and Example 2.

Referring to FIGS. 16 and 17, the transmittance of the window member according to Example 2 exhibited transmittance and reflectance comparable to those of Example 1 and Comparative Example 2 in the wavelength range of approximately 420 nm to approximately 700 nm.

It can be seen from these results that the transmittance and reflectance of the window member according to Example 2, in which the thicknesses of the SiON layer, the AlSiN layer and the SiO₂ layer were increased compared to Example 1, were comparable to those of Example 1 and Comparative Example 2 in the visible wavelength range.

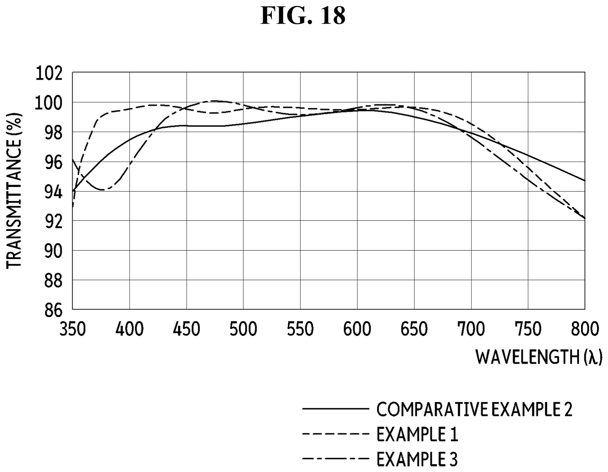

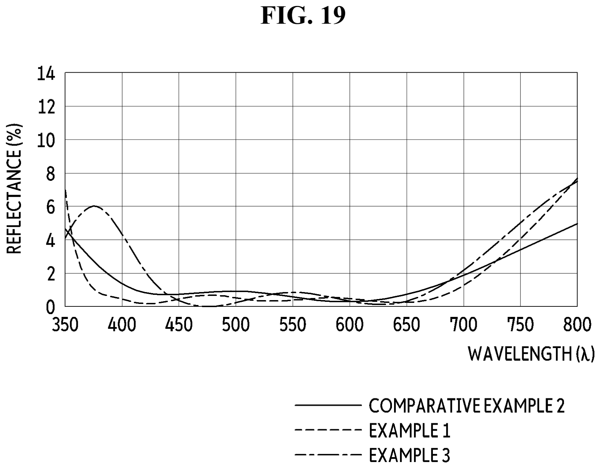

FIG. 18 is a graph showing the transmittance according to the wavelength of window members fabricated according to Comparative Example 2, Example 1, and Example 3. FIG. 19 is a graph showing the reflectance according to the wavelength of window members fabricated according to Comparative Example 2, Example 1, and Example 3.

Referring to FIGS. 18 and 19, the transmittance and the reflectance of the window member according to Example 3 were comparable to those of Example 1 and Comparative Example 2 in the wavelength range of approximately 450 nm to approximately 750 nm.

It can be seen from these results that the transmittance and reflectance of the window member according to Example 3, in which one AlSiN layer was not included and thus the thickness is reduced compared to Example 1, were comparable to those of Example 1 and Comparative Example 2 in the visible wavelength range.

In addition, the cross-sectional reflectance of each of the window members according to Examples 1 to 3 above at the wavelength of 550 nm was less than or equal to 1%, and the average cross-sectional reflectance in the wavelength range of 400 nm to 700 nm was also less than or equal to 1%. For example, it can be seen that the reflectance of the window members according to Examples 1 to 3 were lowered and the transmittance was increased.

### < Experimental Example 2: Measurement of Hardness of Window Member >

The hardness of the window members according to Examples 1 to 3 above was measured. The hardness was measured using a nanoindentation tester commercially available from Anton Paar GmbH.

The window members according to Examples 1 to 3 each exhibited a hardness exceeding 14 GPa.

It can be seen from these results that the hardness of the window members according to Examples 1 to 3 was excellent.

The display device according to an embodiment may be applied to a variety of electronic devices. An electronic device according to an embodiment includes the display device described above, and may further include a module or device having additional features in addition to the display device.

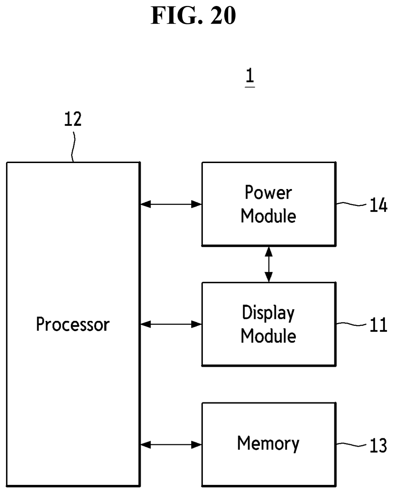

FIG. 20 is a block diagram of an electronic device according to an embodiment of the present disclosure.

Referring to FIG. 20, an electronic device 1 according to an embodiment of the present disclosure may include a display module 11, a processor 12, a memory 13, and a power module 14.

The processor 12 may include at least one of: a central processing unit (CPU), an application processor (AP), a graphic processing unit (GPU), a communication processor (CP), an image signal processor (ISP), and a controller.

The memory 15 may store data information required for the operation of the processor 12 or the display module 11. When the processor 12 executes an application stored in the memory 15, an image data signal and/or an input control signal may be transmitted to the display module 11. The display module 11 may process the received signal and output image information through a display screen.

The power module 14 may include a power supply module such as a power adapter and a battery device, and a power conversion module that converts the power supplied by the power supply module to generate power required for the operation of the electronic device 1.

At least one of the elements of the electronic device 1 described above may be included in the display devices according to embodiments described above. In addition, some of the individual modules functioning as a single module may be included in the display device while some others may be provided separately from the display device. For example, the display device may include the display module 11, and the processor 12, the memory 13 and the power module 14 may be implemented as other devices inside the electronic device 1 instead of the display device.

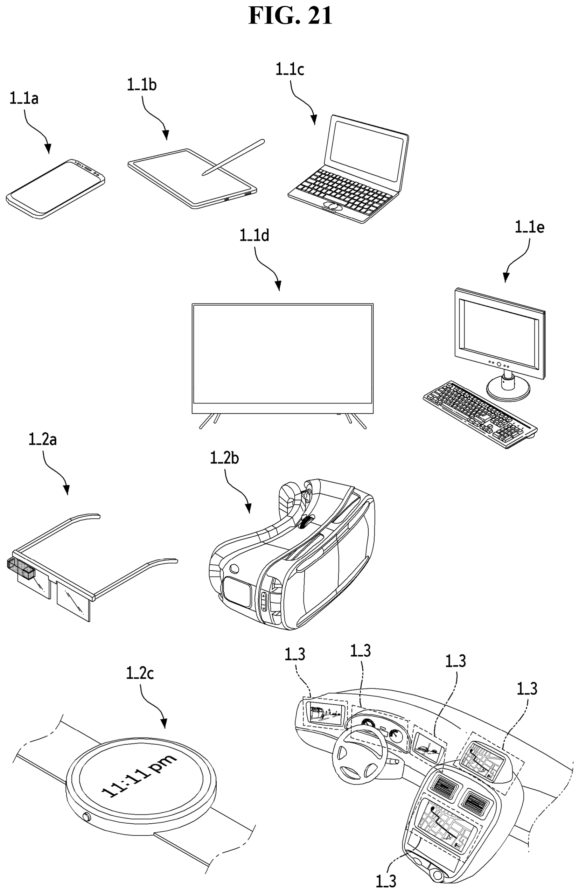

FIG. 21 is a view showing electronic devices according to a variety of embodiments of the present disclosure.

Referring to FIG. 21, a variety of electronic devices employing display devices according to embodiments may include not only image display electronic devices such as a smart phone 1_1a, a tablet PC 1_1b, a laptop computer 1_1c, a TV 1_1d and a desktop monitor 1_1e, but also wearable electronic devices including display modules such as smart glasses 1_2a, a head-mounted display 1_2b and a smart watch 1_2c, and electronic devices for vehicles 1_3 including display modules such as a center information display (CID) placed on the dashboard, the center fascia and the dashboard of a vehicle, and a room mirror display.

As discussed, embodiments of the invention may provide a window member comprising: a cover window; an optical member disposed on the cover window; and a functional member disposed on the optical member, wherein the optical member comprises: a first refractive layer disposed on the cover window; and at least one group disposed on the first refractive layer, the at least one group comprising a second refractive layer and a third refractive layer, the second refractive layer and the third refractive layer having different refractive indices from each other, and wherein the first refractive layer has a first refractive index between a second refractive index of the second refractive layer and a third refractive index of the third refractive layer, and the first refractive layer contains at least silicon.

The second refractive layer may be disposed on the first refractive layer, and the third refractive layer may disposed on the second refractive layer.

The first refractive layer may be in direct contact with a surface of the cover window.

The optical member may comprise at least two groups disposed on the first refractive layer, with each of the at least two groups comprising a second refractive layer and a third refractive layer. The second refractive layers and the third refractive layer of the optical member may be alternately stacked. As an example, the optical member may comprise two groups, with a first refractive layer, a second refractive layer, a third refractive layer, a second refractive layer, and a third refractive layer stacked in that order.

The second refractive index of the second refractive layer may be greater than the first refractive index of the first refractive layer.

The second refractive index of the second refractive layer may be greater than the third refractive index of the third refractive layer.

The third refractive index of the third refractive layer may be less than the first refractive index of the first refractive layer.

The third refractive index of the third refractive layer may be less than the second refractive index of the second refractive layer.

The third refractive layer may be spaced apart from an upper surface of the cover window.

The thickness of the first refractive layer may be in the range of about 10% to about 40% with respect to the total thickness of the optical member.

The thickness of the first refractive layer may be in the range of about 75% to about 95% of the thickness of the third refractive layer disposed at the uppermost layer of the optical member.

The thickness of each of the second refractive layers may be in a range of about 130% to about 240% of the thickness of the third refractive layer disposed at the uppermost layer of the optical member.

The thickness of each third refractive layer may be in a range of about 1% to about 30% of the total thickness of the optical member.

The thickness of the third refractive layer at the top of the optical member may be in a range of about 80% to about 90% of the sum of the thicknesses of all third refractive layers 430 included in the optical member.

The thicknesses of the first refractive layer and the second refractive layers with respect to the total thickness of the optical member may be in a range of about 70% to about 90%.

Embodiments may provide an electronic device comprising: a display device arranged to provide images; a processor arranged to provide an image data signal to the display device; a memory arranged to store a data signal for driving; and a power module arranged to generate power, wherein the display device comprises: a display panel; an adhesive member arranged on the display panel; a window member according to any the above-mentioned embodiments, wherein the cover window is arranged on the adhesive member.

In concluding the detailed description, those skilled in the art will appreciate that many variations and modifications can be made to the described embodiments without substantially departing from the principles of the present disclosure. Therefore, the described embodiments of the invention are used in a generic and descriptive sense only and not for purposes of limitation.

## Claims

1. A window member comprising:
a cover window;
an optical member disposed on the cover window; and
a functional member disposed on the optical member,
wherein the optical member comprises:
a first refractive layer disposed on the cover window; and
at least one group disposed on the first refractive layer, the at least one group comprising a second refractive layer and a third refractive layer, the second refractive layer and the third refractive layer having different refractive indices from each other, and
wherein the first refractive layer has a first refractive index between a second refractive index of the second refractive layer and a third refractive index of the third refractive layer, and the first refractive layer contains at least silicon.

2. The window member of claim 1, wherein the optical member comprises at least two groups disposed on the first refractive layer, each of the at least two groups comprising a second refractive layer and a third refractive layer;
optionally wherein the second refractive layers and the third refractive layer of the optical member are alternately stacked.

3. The window member of claim 1 or 2, wherein the first refractive layer comprises an oxide containing silicon, an oxynitride containing silicon, or a nitride containing silicon;
optionally wherein the first refractive layer further contains a metal, and the metal comprises aluminum.

4. The window member of any one of claims 1 to 3, wherein the second refractive index of the second refractive layer is greater than the first refractive index of the first refractive layer and the third refractive index of the third refractive layer.

5. The window member of any one of claims 1 to 4, wherein the third refractive index of the third refractive layer is less than the first refractive index of the first refractive layer and the second refractive index of the second refractive layer;
optionally wherein the third refractive layer is spaced apart from an upper surface of the cover window.

6. The window member of any one of claims 1 to 5, wherein the first refractive layer is in direct contact with a surface of the cover window, the second refractive layer is disposed on the first refractive layer, and the third refractive layer is disposed on the second refractive layer.

7. The window member of any one of claims 1 to 6, wherein the first refractive index of the first refractive layer is between a fourth refractive index of the cover window and the second refractive index of the second refractive layer.

8. The window member of any one of claims 1 to 7, wherein:
the first refractive index of the first refractive layer is in a range of about 1.4 to about 1.9;
the second refractive index of the second refractive layer is greater than about 1.9 and equal to or less about 2.3; and
the third refractive index of the third refractive layer is greater than about 1.3 and less than about 1.5.

9. The window member of any one of claims 1 to 8, wherein:
the first refractive layer comprises an oxynitride containing at least silicon; and
the first refractive layer is in direct contact with a surface of the cover window.

10. The window member of any one of claims 1 to 9, wherein a thickness of the first refractive layer is in a range of about 75% to about 95% of a thickness of the third refractive layer disposed at an uppermost layer of the optical member; or
wherein a thickness of the second refractive layer is in a range of about 130% to about 240% of a thickness of the third refractive layer disposed at an uppermost layer of the optical member.

11. The window member of any one of claims 1 to 10, wherein a thickness of the third refractive layer is in a range of about 1% to about 30% of a total thickness of the optical member.

12. The window member of any one of claims 1 to 11, wherein the functional member comprises an anti-fingerprint layer, wherein a refractive index of the anti-fingerprint layer is equal to the third refractive index of the third refractive layer in direct contact with the anti-fingerprint layer.

13. The window member of any one of claims 1 to 12, wherein an upper surface of the cover window facing the first refractive layer comprises a rough structure.

14. The window member of any one of claims 1 to 13, wherein the first refractive layer comprises an oxynitride containing silicon, the second refractive layer comprises a nitride containing silicon, and the third refractive layer comprises an oxide containing silicon.

15. An electronic device comprising:
a display device arranged to provide images;
a processor arranged to provide an image data signal to the display device;
a memory arranged to store a data signal for driving; and
a power module arranged to generate power,
wherein the display device comprises:
a display panel;
an adhesive member arranged on the display panel; and
a window member according to any of claims 1 to 14, wherein the cover window is arranged on the adhesive member.
